# EUROPEAN PATENT APPLICATION

(11) **EP 4 528 787 A1**
(43) Date of publication of application: **26.03.2025**
(21) Application number: 24201887.7
(22) Date of filing: 23.09.2024
(51) Int. Cl.: H01L 21/02

(54) **POLYCRYSTALLINE SILICON CARBIDE (SIC) SUBSTRATE WITH HIGH RESISTIVITY AND METHOD OF MANUFACTURING THE SAME**

(30) Priority: 25.09.2023 SE 2351099; 17.09.2024 US 202418887762
(71) Applicant: STMicroelectronics International N.V., 1228 Plan-les-Ouates, Geneva (CH)
(72) Inventor: MAGNUSSON LINDGREN, Bjorn, 60379 Norrköping (SE); KARLSSON, Niclas, 58729 Linköping (SE); HAMALAINEN, Esa, 60219 Norrköping (SE); ELLISON, Alexandre, 58731 Linköping (SE)
(74) Representative: Studio Torta S.p.A.

(57) **Abstract**

A polycrystalline SiC wafer or substrate with a high resistivity benefits functionality of a high power electronic or system in which the polycrystalline SiC wafer or substrate is present or is utilized in manufacturing the high power electronic or system. At least one embodiment of a wafer includes a polycrystalline SiC wafer or substrate that has a high resistivity (e.g., equal to or greater than 1·10^5 or 1E+5 ohm·centimeters) and low warpage. Electronic devices or components made with or from the wafer including the high resistivity polycrystalline SiC wafer or substrate are further optimized when in use and have fewer to no crystal defects. The wafer formed according to the embodiments of the present disclosure has a high or very high resistivity as compared to existing polycrystalline SiC wafers or substrate.

## Description

### BACKGROUND

### TECHNICAL FIELD

The present invention is directed to a high resistivity polycrystalline substrate, as well as a method of manufacturing the high resistivity polycrystalline substrate.

### DESCRIPTION OF THE RELATED ART

The semiconductor industry has been showing considerable interest in silicon carbide (SiC), in particular for the manufacture of devices or components (*e*.*g*., radars, diodes, transistors, or other similar or like applications).

Development and manufacture of silicon carbide based electronic devices are limited by factors such as electrical and mechanical properties from forming silicon carbide wafers. Many manufactured silicon carbide wafers have a low resistivity, which is beneficial for the final products. Another issue is an amount of warpage that comes from the manufacturing of the wafer. A lesser resistivity allows for an ability of an electrical signal to more readily travel through the silicon carbide wafer, but limits the ability for the silicon carbide wafer to be utilized in high power applications (*e*.*g*., radar) where instead a high resistivity is desired. Also, a higher amount of warpage results in defects when manufacturing the end electronic devices, such as from the polishing processes, or results in an increase in a number of cracked or broken wafers or substrates during processing and manufacturing.

These polycrystalline SiC wafers may be manufactured by a method of bonding a single crystal (*i.e.,* monocrystalline) wafer onto the polycrystalline SiC wafer. For example, there is a wafer manufacturing method in which the polycrystalline SiC wafer and the single crystal (*i.e.,* monocrystalline) SiC wafers are bonded and integrated together by direct bonding. In a power device, these crystal defects, low resistivity, and high warpage may be problematic for high power applications as these factors limit the functionality of the power device such that the power device functions outside of selected tolerances. In such situations, these devices may be disposed of (*e.g*., thrown out), which increases manufacturing costs due to a decrease in yield.

### BRIEF SUMMARY

The present invention relates to a device and a method, as defined in the annexed claims.

In detail:
A polycrystalline SiC wafer or substrate with a high resistivity benefits functionality of a high power electronic or system in which the polycrystalline SiC wafer or substrate is present or is utilized in manufacturing the high power electronic or system. The present disclosure is directed to providing at least one embodiment of a wafer including a polycrystalline SiC wafer or substrate that has a high resistivity (*e*.*g*., equal to or greater than 1·10^5 or 1E+5 ohm·centimeters and low warpage. Electronic devices or components made with or from the wafer including the high resistivity polycrystalline SiC wafer or substrate are further optimized when in use and have fewer to no crystal defects. The wafer formed according to the embodiments of the present disclosure has a high or very high resistivity as compared to existing polycrystalline SiC wafers or substrate.

At least one embodiment of the present disclosure is summarized as comprising: a polycrystalline silicon carbide (SiC) base substrate including: a first surface, a second surface opposite to the first surface, a resistivity greater than or equal to 1·10^5 or 1E+5 ohm·cm, and a grain size equal to or greater than 0.5 millimeters (mm).

In some embodiments, a monocrystalline silicon carbide (SiC) substrate is coupled to the first surface of the polycrystalline silicon carbide (SiC) base substrate. The monocrystalline silicon carbide (SiC) may have a resistivity similar to or equal to the resistivity of the polycrystalline silicon carbide substrate.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1 is directed to a perspective side view of an embodiment of a wafer of the present disclosure;
Figure 2 is directed to a perspective view of an alternative embodiment of a wafer of the present disclosure;
Figure 3A is directed to a top plan view of another alternative embodiment of a wafer of the present disclosure;
Figure 3B is directed to a perspective side view of the another alternative embodiment of the wafer as shown in Figure 3A of the present disclosure;
Figure 3C is directed to a zoomed-in, enhanced view of section 3C-3C as shown in Figure 3C of the another embodiment of the wafer of the present disclosure;
Figure 4A is a flowchart of a method of manufacturing the embodiments of the wafers of the present disclosure as shown in Figures 1 and 2;
Figure 4B is a flowchart of a method of manufacturing the another embodiment of the wafer as shown in Figures 3A-3C of the present disclosure;
Figure 4C is a flowchart of an alternative method of manufacturing the another embodiment of the wafer as shown in Figures 3A-3C of the present disclosure; and
Figures 5A-5C are side views of at least some steps of the embodiments of the method of manufacturing as shown in Figure 4A to manufacture the embodiments of the wafers as shown in Figures 1 and 2 of the present disclosure.

### DETAILED DESCRIPTION

In the following description, certain details are set forth in order to provide a thorough understanding of various embodiments of devices, methods and articles. However, one of skill in the art will understand that other embodiments may be practiced without these details. In other instances, well-known structures and methods associated with, for example, silicon carbide substrates or layers (*e*.*g*., polycrystalline silicon carbide, monocrystalline silicon carbide, etc.), semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The headings are provided for convenience only, and do not interpret the scope or meaning of this disclosure or the claims.

The sizes and relative positions of elements in the drawings are not necessarily drawn to scale. For example, the shapes of various elements and angles may not be drawn to scale, and some of these elements may be enlarged and positioned to improve drawing legibility.

The use of "transverse" means that a surface, a sidewall, or similar or like structure or feature is at an angle with respect to another respective surface, sidewall, or similar or like respective structure or feature. For example, if a first surface is transverse to a first sidewall, the first surface may be at an angle that is equal to 25-degrees, 35-degrees, 45-degrees, 75-degrees, 90-degrees, 120-degrees, and so forth.

Generally, polycrystalline silicon carbide (SiC) substrates, wafers or layers have been utilized within various electronic devices and components (*e*.*g*., semiconductor die, semiconductor packages, semiconductor transistors, etc.). These polycrystalline SiC substrates, wafers, or layers have a resistivity that results in a resistance being present along an electrical pathway that passes through or along the polycrystalline SiC substrates, wafer, or layers. This resistance impedes an electrical signal as it passes through or along the electrical pathways and is known as an on-resistance (Rₒₙ). This on-resistance (Rₒₙ) of the polycrystalline SiC substrates, wafers, or layers is generally high when utilized in high power and high frequency applications (*e*.*g*., radar or other similar or like types of radiofrequency applications or devices at gigahertz (GHz) frequencies, which are relatively high as compared to other situations). For example, when the on-resistance (Rₒₙ) due to the polycrystalline SiC substrate having a high resistivity (*e*.*g*., greater than or equal to 1·10^5 or 1E+5 ohm·centimeters), the polycrystalline SiC substrate with the high and stable resistivity provides good electrical performance as well as reduced insertion loss such that the polycrystalline SiC substrate is optimized for use in high power and high frequency applications. Within industry monocrystalline SiC substrates with high resistivities have been manufactured with high resistivities for such high frequency and high power applications, but manufacturing monocrystalline SiC substrates is significantly more expensive and costly than manufacturing polycrystalline SiC substrates. In view of this, the present disclosure is directed to one or more embodiments of a polycrystalline SiC substrate with a high resistivity optimized for use within high power and high frequency applications, as well as methods of manufacturing the polycrystalline SiC substrate with high resistivity.

A polycrystalline SiC substrate or wafer with a high resistivity of a high power and high frequency electronic device in which the polycrystalline SiC substrate or wafer is present. The present disclosure is directed to providing at least one embodiment of a wafer or substrate including a polycrystalline SiC substrate or wafer that has a high resistivity and a low warpage. Electronic devices or components made from or including the polycrystalline SiC substrate or wafer that has the high resistivity and low warpage function stably at high powers and high frequencies. The embodiments of the polycrystalline SiC substrates or wafers of the present disclosure are further optimized as these embodiments of the polycrystalline SiC substrates or wafers of the present disclosure have fewer crystal defects. The polycrystalline SiC substrate or wafers have a high or very high resistivity as compared to existing polycrystalline SiC substrates or wafers, which are generally manufactured to have a resistivity much less than 1·10^5 or 1E+5 ohm·centimeters. Furthermore, the low amount of warpage in the embodiments of the polycrystalline SiC substrates or wafers of the present disclosure prevents or reduces the likelihood of defects when manufacturing the end electronic devices, such as from polishing process, or results in a decrease in a number of cracked or broken polycrystalline SiC wafers or substrates during processing and manufacturing.

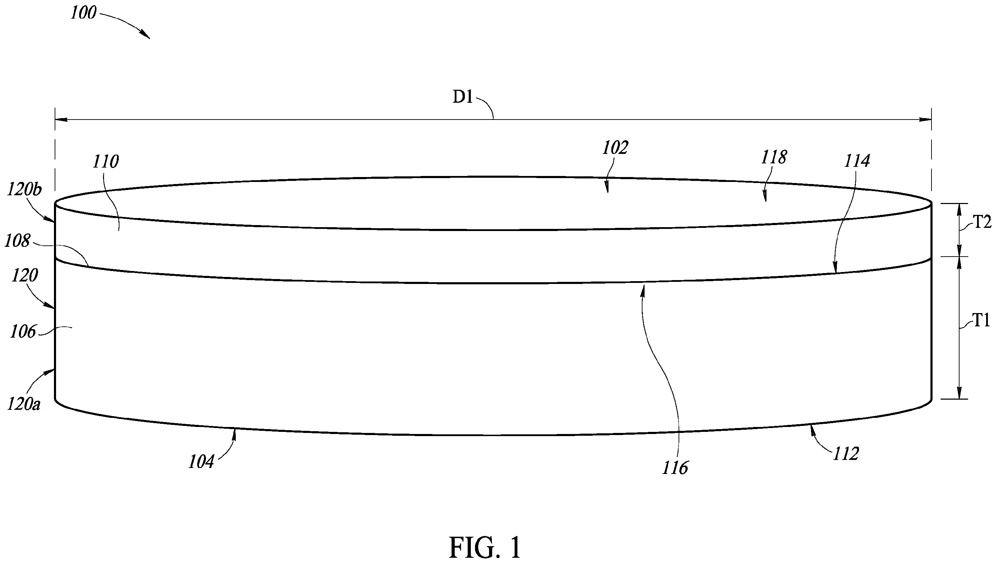

Figure 1 is a side view of an embodiment of a wafer 100 of the present disclosure. The wafer 100 includes a first side 102 and a second side 104 that is opposite to the first side 102. The wafer 100 further includes a polycrystalline silicon carbide (SiC) layer 106, a bonding region 108, and a monocrystalline silicon carbide (SiC) layer 110 that is bonded to the polycrystalline silicon carbide layer 106 at the bonding region 108. The polycrystalline silicon carbide layer 106 may be referred to as a polycrystalline silicon carbide substrate, a polycrystalline silicon carbide wafer, a polycrystalline silicon carbide layer, or may be referred to in some other suitable manner. The monocrystalline silicon carbide (SiC) layer 110 may be referred to as a monocrystalline silicon carbide substrate, a monocrystalline silicon carbide wafer, a monocrystalline silicon carbide layer, or may be referred to in some other suitable manner. The polycrystalline silicon carbide (SiC) layer 106 may be referred to as a polycrystalline layer 106 hereafter within the present disclosure, and the monocrystalline silicon carbide (SiC) layer 110 may be referred to as a monocrystalline layer 110 hereafter within the present disclosure.

The polycrystalline layer 106 has a high resistivity, for example, a resistivity greater than or equal to 1·10^5 or 1E+5 ohm·cm. This high resistivity of the polycrystalline layer 106 allows for an electrical signal (*e.g.,* electrons) at high powers and high frequencies (*e.g.,* gigahertz (GHz) levels of frequency) to stably pass through the polycrystalline layer 106 at high power and high frequency such that the electrical signal may travel stably through the polycrystalline layer 106 and may reach its destination being more accurate and stable in strength and precision as compared to when the polycrystalline layer 106 instead has a low resistivity. In other words, when the on-resistance (Rₒₙ) of the polycrystalline layer 106 is high (*i.e*., high resistivity) the high power and high frequency electrical signal will more readily stably pass through the polycrystalline layer 106 without inaccuracies developing as the high power and high frequency electrical signal pass through the polycrystalline layer 106 when traveling to its destination within a high power and high frequency electronic device (*e*.*g*., radar, semiconductor package, semiconductor die, or some other similar or like high power and high frequency electronic devices in which the polycrystalline layer 106 may be present).

The polycrystalline layer 106 includes a first surface 112 and a second surface 114 opposite to the first surface 112. The first surface 112 of the polycrystalline layer 106 is at the second side 104 of the wafer 100. The monocrystalline layer 110 includes a third surface 116 and a fourth surface 118 opposite to the third surface 116. The fourth surface 118 of the monocrystalline layer 110 is at the first side 102 of the wafer 100.

The polycrystalline layer 106 has a first thickness T1, which may be referred to as a first dimension. The first thickness T1 extends from the first surface 112 of the polycrystalline layer 106 to the second surface 114 of the polycrystalline layer 106. In some embodiments, the first thickness T1 may be within the range 150-1000 micrometers (µm) or equal to the upper and lower ends of this range (*e.g*., the first thickness T1 may be equal to 150 micrometers (µm) or may be equal to 1000 micrometers (µm)). In some embodiments, the first thickness T1 may be less than or equal to 1 millimeter (mm).

The monocrystalline layer 110 has a second thickness T2, which may be referred to as a second dimension. The second thickness T2 extends from the third surface 116 of the monocrystalline layer 110 to the fourth surface 118 of the monocrystalline layer 110. The second thickness T2 of the monocrystalline layer 110 may be less than the first thickness T1 of the polycrystalline layer 106. The second thickness T2 of the monocrystalline layer 110 may be within the range 0.3-2 micrometers (µm) or equal to the upper and lower ends of this range (*e.g*., the second thickness T2 may be equal to 0.3 micrometers (µm) or may be equal to 2 micrometer (µm)). In some embodiments, the second thickness may be within the range 0.3-1 micrometers (µm) or equal to the upper and lower ends of this range (*e.g*.*,* the second thickness T2 may be equal to 0.3 micrometers (µm) or may be equal to 1 micrometer (µm)). In some embodiments, the second thickness T2 of the monocrystalline layer 110 may be equal to 0.5 micrometers (µm). In some embodiments, the second thickness T2 may be less than or equal to 20-200 micrometers (µm) or equal to the upper and lower ends of this range (*e.g*., the second thickness T2 may be equal to 20 micrometers (µm) or may be equal to 200 micrometers (µm)). In some embodiments, the second thickness T2 may be equal to 120 micrometers (µm).

The monocrystalline layer 110 may have a resistivity between 1E5 (1·10^5) to 1E12 (1·10^12) ohm·centimeters (ohm·cm) or equal to the upper and lower ends of this range.

In the embodiment of the wafer 100 as shown in Figure 1, the bonding region 108 is present between the first surface 112 of the polycrystalline layer 106 and second surface 114 of the monocrystalline layer 110, and the bonding region 108 is a location at which the second surface 114 of the polycrystalline layer 106 is directly bonded to the monocrystalline layer 110. In some embodiments, the monocrystalline layer 110 is directly bonded to the polycrystalline layer 106 by utilizing a surface activated bonding (SAB) technique. In other words, there is no material (*e*.*g*., an adhesive) present between the monocrystalline layer 110 and the polycrystalline layer 106. For example, in the surface activated bonding technique the second surface 114 of the polycrystalline layer 106 and the third surface 116 of the monocrystalline layer 110 can be bombarded by Argon (Ar) ions or neutral atoms (*e*.*g*., a beam of particles that may be Argon (Ar), may be neutral atoms, or may be some other similar or like type of particle or atom that may be suitable) in an ultra-high vacuum to clean and activate the second surface 114 of the polycrystalline layer 106 and the third surface 116 of the monocrystalline layer 110. After the second surface 114 of the polycrystalline layer 106 and the third surface 116 of the monocrystalline layer 110 are cleaned and activated, the second surface 114 of the polycrystalline layer 106 and the third surface 116 of the monocrystalline layer 110 are bonded spontaneously by contacting the second surface 114 of the polycrystalline layer 106 with the third surface 116 of the monocrystalline layer 110. This contacting of the second surface 114 of the polycrystalline layer 106 with the third surface 116 of the monocrystalline layer 110 may be done without heat treatment.

The wafer 100 further includes at least one sidewall 120 (*e.g.,* circular in the embodiment as shown in Figure 1) along which at least one first sidewall 120a of the polycrystalline layer 106 and at least one second sidewall 120b of the monocrystalline layer 110 are coplanar and flush with each other, respectively. In other words, the at least one sidewall 120 includes and is defined by the respective sidewalls of the polycrystalline layer 106, the bonding layer 202, and the monocrystalline layer 110, respectively. The bonding layer 202 includes a sidewall 120c that is coplanar with the sidewalls 120a of the polycrystalline layer 106 and the sidewall 120b of the monocrystalline layer 110.

As discussed earlier herein, the polycrystalline layer 106 has a high resistivity, for example, a resistivity greater than or equal to 1·10^5 or 1E+5 ohm·cm. In some alternative embodiments, the polycrystalline layer 106 has a high resistivity within the range of 1·10^5 (1E+5) to 1·10^12 (1E+12) ohm·cm or equal to the upper and lower ends of this range. In some alternative embodiments, the polycrystalline layer 106 has a high resistivity within the range of 1·10^5 to 1·10^9 ohm·cm or equal to the upper and lower ends of this range. In some alternative embodiments, the polycrystalline layer 106 has a high resistivity within the range of 1·10^9 (1E9) to 1·10^12 (1E+12) ohm·cm or equal to the upper and lower ends of this range. This high resistivity of the polycrystalline layer 106 allows for an electrical signal (*e*.*g*., electrons) to pass through the polycrystalline layer 106 stably without becoming inaccurate when passing through the polycrystalline layer 106 such that the high power and high frequency electrical signal may travel through the polycrystalline layer 106 stably and may reach its destination with a higher level of accuracy as compared to when the polycrystalline layer 106 instead has a low resistivity (*e*.*g*., less than 1·10^5 or 1E+5 ohms-centimeter. In other words, when the on-resistance (Rₒₙ) of the polycrystalline layer 106 is high (*i.e.,* high resistivity), the electrical signal will more stably and accurately pass through the polycrystalline layer 106 without becoming inaccurate when traveling to its destination through the polycrystalline layer 106 within an electronic device (*e*.*g.*, semiconductor package, semiconductor die, or some other similar or like electronic device in which the polycrystalline layer 106 may be present).

While not shown in Figure 1, in some alternative embodiments of the wafer 100, a silicon oxide (*e.g*., SiO₂) layer may be present at the bonding region 108 such that the silicon oxide layer is between the polycrystalline layer 106 and the monocrystalline layer 110.

The wafer 100 has a diameter D1 that extends from opposite points along a peripheral edge of the wafer 100. The diameter D1 may be within the range from 150 to 300 millimeters (mm) and may be equal to the upper and lower ends of this range.

The embodiment of the wafer 100 may have some warpage, which may be some bending or bowing within embodiment of the wafer 100 that may result in the second surface 114 of the polycrystalline layer 106 being slightly curved or having a slight curvature. However, while some warpage may be present in the wafer 100, the warpage in the wafer 100 is less than or equal to 75 micrometers (µm) or may be less than or equal to 45 micrometers (µm). The warpage may be measured as a distance from a center point of the wafer to a point at or near an edge of the wafer in a direction transverse to the second surface 114 of the wafer.

The second surface 114 of the polycrystalline layer 106 may have a roughness less than or equal to 20 Angstrom (Å). In some embodiments, the second surface 114 of the polycrystalline layer 106 may have a roughness in the range of 1-5 Angstrom (Å) and may be equal to the lower and upper ends of this range (*e.g.,* a roughness may be equal to 1 Angstrom (Å) or may be equal to 5 Angstrom (Å)). This roughness of the second surface 114 may be obtained by polishing the second surface 114.

The third surface 116 of the monocrystalline layer 110 may have a roughness less than or equal to 20 Angstrom (Å). In some embodiments, the third surface 116 of the monocrystalline layer 110 may have a roughness in the range of 1-5 Angstrom (Å) and may be equal to the lower and upper ends of this range *(e.g.,* the roughness may be equal to 1 Angstrom (Å) or may be equal to 5 Angstrom (Å)). This roughness of the third surface 116 may be obtained by polishing the third surface 116.

The fourth surface 118 of the monocrystalline layer 110 may have a roughness less than or equal to 20 Angstrom (Å). In some embodiments, the fourth surface 118 of the monocrystalline layer 110 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the fourth surface 118 may be obtained by polishing or planarizing the fourth surface 116. In some embodiments, a roughness at the first surface 112 of the polycrystalline layer 106 may be greater than or equal to the roughness of the second surface 114 of the polycrystalline layer 106. This roughness of the first surface 112 may be obtained by polishing or planarizing the first surface 112.

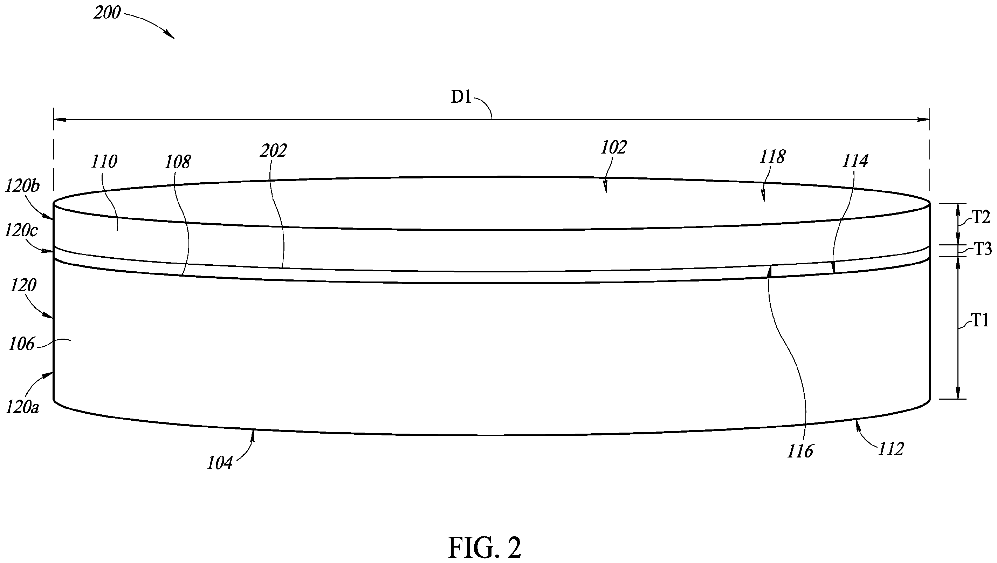

Figure 2 is directed to a perspective side view of an alternative embodiment of a wafer 200, which has several of the same or similar features as the embodiment of the wafer 100 as shown in Figure 1. The same or similar features of the wafer 200 relative to the wafer 100 have the same or similar reference numerals. Accordingly, the following discussion of the alternative embodiment of the wafer 200 as shown in Figure 2 will focus on the different or additional features or details as compared to the embodiment of the wafer 100 as shown in Figure 1.

Unlike the embodiment of the wafer 100 as shown in Figure 1 in which the second surface 114 of the polycrystalline layer 106 is directly bonded to the third surface 116 of the monocrystalline layer 110, in the embodiment of a wafer 200 as shown in Figure 2 a bonding layer 202 is present at the bonding region 108 and couples together the polycrystalline layer 106 to the monocrystalline layer 110. For example, before the surface activated bonding (SAB) technique as discussed earlier herein is performed, a first conductive layer may be formed on the second surface 114 of the polycrystalline layer 106 and a second conductive layer may be formed on the third surface 116 of the monocrystalline layer 110. The first and second conductive layers may be made of the same or different conductive materials that are suitable to be bonded together utilizing the SAB technique. In some embodiments, the first and second conductive layers, respectively, may be formed on the second surface 114 of the polycrystalline layer 106 and the third surface 116 of the monocrystalline layer 110, respectively, by a sputtering technique or by some other technique suitable for forming the first and second conductive layers, respectively, on the second surface of the polycrystalline layer 106 and the third surface 116 of the monocrystalline layer 110, respectively.

After the first and second conductive layers, respectively, have been formed on the second surface 114 of the polycrystalline layer 106 and the third surface 116 of the monocrystalline layer 110, respectively, the surface activated bonding technique is performed such that the first and second conductive layers are bombarded by Argon (Ar) ions or neutral atoms (*e*.*g*., a beam of particles that may be Argon (Ar), may be neutral atoms, or may be some other similar or like type of particle or atom that may be suitable) in an ultra-high vacuum to clean and activate the first and second conductive layers, respectively, on the second surface 114 of the polycrystalline layer 106 and on the third surface 116 of the monocrystalline layer 110, respectively. After the first and second conductive layers are cleaned and activated, the first conductive layer on the second surface 114 of the polycrystalline layer 106 and the second conductive layer on the third surface 116 of the monocrystalline layer 110 are bonded spontaneously by contacting the first conductive layer on the second surface 114 of the polycrystalline layer 106 with the second conductive layer on the third surface 116 of the monocrystalline layer 110. This contacting of the first conductive layer on the second surface 114 of the polycrystalline layer 106 with the second conductive layer on the third surface 116 of the monocrystalline layer 110 may be done without heat treatment. Once the first conductive layer on the second surface 114 of the polycrystalline layer 106 is bonded to the second conductive layer on the third surface 116 of the monocrystalline layer 110, the bonding layer 202 between the polycrystalline layer 106 and the monocrystalline layer 110 is formed.

In some alternative embodiments, instead of forming both the first and second conductive layers as discussed above, only one of the first or the second conductive layers may be formed on only one of the second surface 114 of the polycrystalline layer 106 or the third surface 116 of the monocrystalline layer 110. After only one of the first or second conductive layers is formed, the SAB technique is carried out in the same or similar fashion as discussed earlier herein either with respect to Figure 1 or Figure 2 except that at least one of the second surface 114 of the polycrystalline layer 106 or the third surface 116 of the monocrystalline layer 110 remains uncovered and is exposed to the Argon or neutral atom beam.

Either both the first and second conductive layers or at least one of the first or second conductive layers may be formed when a first material of the polycrystalline layer 106 is not compatible with directly bonding to a second material of the monocrystalline layer 110. In other words, either both the first and second conductive layers or at least one of the first or second conductive layers may be formed to facilitate coupling together the polycrystalline layer 106 to the monocrystalline layer 110 when the first material of the polycrystalline layer 106 is not compatible with the second material of the monocrystalline layer 110.

When the bonding layer 202 is present between the second surface 114 of the polycrystalline layer 106 and the third surface of the monocrystalline layer 110, the bonding layer 202 has a third thickness T3, which may be referred to as a third dimension. The third thickness T3 extends from the second surface 114 of the polycrystalline layer 106 to the third surface 116 of the monocrystalline layer 110. The third thickness T3 may be less than the first thickness T1. The third thickness T3 of the bonding layer 202 may be within the range from 0.2-5 micrometers (µm) and may be equal to the upper and lower ends of this range (*e.g*., the third thickness T3 may be equal to 0.2 micrometers (µm) or may be equal to 5 micrometers (µm)). In some embodiments, the third thickness may be equal to 0.5 micrometers (µm).

The alternative embodiment of the wafer 200 may have some warpage, which may be some bending or bowing within the alternative embodiment of the wafer 200 that may result in the second surface 114 of the polycrystalline layer 106 being slightly curved or having a slight curvature. However, while some warpage may be present in the alternative embodiment of the wafer 200, the warpage in the alternative embodiment of the wafer 200 may be less than or equal to 75 micrometers (µm) or may be less than or equal to 45 micrometers (µm).

The second surface 114 of the polycrystalline layer 106 may have a roughness less than or equal to 20 Angstrom (Å). In some embodiments, the second surface 114 of the polycrystalline layer 106 may have a roughness in the range of 1-5 Angstrom (Å) and may be equal to the lower and upper ends of this range (*e.g*., the roughness may be equal to 1 Angstrom (Å) or may be equal to 5 Angstrom (Å)). This roughness of the second surface 114 may be obtained by polishing the second surface 114.

The third surface 116 of the monocrystalline layer 110 may have a roughness less than or equal to 20 Angstrom (Å). In some embodiments, the third surface 116 of the polycrystalline layer 106 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the third surface 116 may be obtained by polishing the third surface 116.

The fourth surface 118 of the monocrystalline layer 110 may have a roughness less than or equal to 20 Angstrom (Å). In some embodiments, the fourth surface 118 of the monocrystalline layer 110 may have a roughness in the range of 1-5 Angstrom (Å) and may be equal to the lower and upper ends of this range (*e.g*., the roughness may be equal to 1 Angstrom (Å) or may be equal to 5 Angstrom (Å)). This roughness of the fourth surface 118 may be obtained by polishing or planarizing the fourth surface 116.

In some embodiments, a roughness at the first surface 112 of the polycrystalline layer 106 may be greater than or equal to the roughness of the second surface 114 of the polycrystalline layer 106. This roughness of the first surface 112 may be obtained by polishing or planarizing the first surface 112.

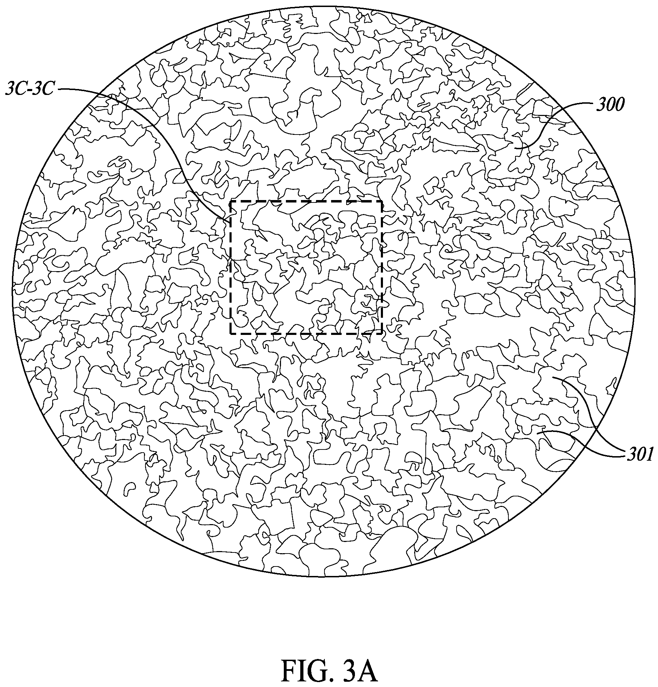

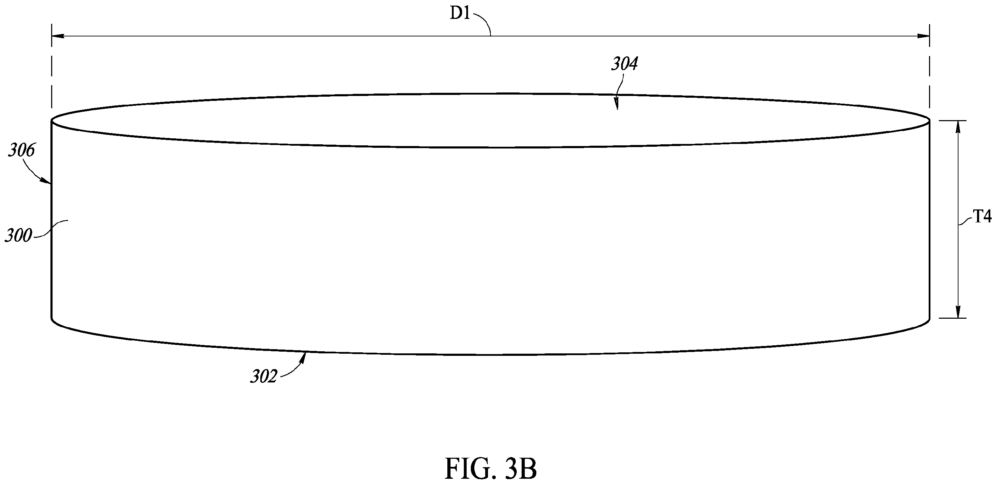

Figure 3A is a top plan view of an embodiment of a polycrystalline substrate 300. As shown in Figure 3A, grains 301 of the polycrystalline substrate 300 at readily visible at a second surface 304 opposite to a first surface 302 (see Figure 3B of the present disclosure for the first and second surfaces 302, 304). The grains 301 have an average grain size greater than 0.5 millimeters (mm). In some embodiments the average grain size is greater than 1 millimeter (mm). In some embodiments, the grain size is within the range of 0.5 to 2 millimeters (mm), or the average grain size is equal to the upper and lower ends of this range. In some embodiments, the grain size is within the range of 1 to 2 millimeters (mm), or the average grain size is equal to the upper and lower ends of this range.

The average grain size may be determined utilizing a line intercept technique or model. In this technique, a random straight line is drawn through a micrograph image of a selected area of a substrate. Once the random straight line is selected, a number of grain boundaries intersected by the random straight line is counted. Once the number of grain boundaries intersecting the random straight line is determined, a length of the random straight line is divided by the number of grain boundaries intersecting divided by a length of the random straight line. Alternatively, this process may be completed with multiple random straight lines, the number of intersections with the grain boundaries for these multiple random straight lines is counted and then a total summation of the lengths of the multiple straight lines is divided by the total number of intersected grain boundaries providing the average grain size of the grains of the substrate.

Figure 3B is a perspective side view of the embodiment of the polycrystalline substrate 300, which may be a polycrystalline wafer, before a monocrystalline substrate or wafer (*e*.*g*., monocrystalline layer 110) has been coupled or bonded to the polycrystalline substrate 300. The polycrystalline substrate 300 has the diameter D1. The polycrystalline substrate 300 may be utilized in forming the polycrystalline layer 106 in the embodiment of the wafer 100 and the alternative embodiment of the wafer 200. The polycrystalline substrate 300 includes a first surface 302, a second surface 304 opposite to the first surface 302, and a sidewall 306 that extends from the first surface 302 to the second surface 304 and is transverse to the first and second surfaces 302, 304. The second surface 304 of the polycrystalline substrate 300 may correspond to the second surface 114 of the polycrystalline layer 106 as in the embodiment of the wafer 100 and the alternative embodiment of the wafer 200. The sidewall 306 of the polycrystalline substrate 300 may correspond to the at least one first sidewall 120a of the polycrystalline layer 106 as in the embodiment of the wafer 100 and the alternative embodiment of the wafer 200.

A fourth thickness T4 of the polycrystalline substrate 300 extends from the first surface 302 to the second surface 304 of the polycrystalline substrate 300. The fourth thickness T4 may be larger than or equal to the third thickness T3 of the polycrystalline layer 106 as in the embodiment of the wafer 100 and the alternative embodiment of the wafer 200. The fourth thickness T4 may be within the range of 150 micrometers (µm) to 1000 micrometers (µm) or may be equal to the lower and upper ends of this range.

The polycrystalline substrate 300 has a high resistivity, for example, a resistivity greater than or equal to 1·10^5 or 1E+5 ohms-centimeter.

The embodiment of the polycrystalline substrate 300 may have some warpage, which may be some bending or bowing within the embodiment of the polycrystalline substrate 300 that may result in the second surface 304 of the polycrystalline layer 106 being slightly curved or having a slight curvature. However, while some warpage may be present in the polycrystalline substrate 300, the warpage in the polycrystalline substrate 300 may be less than or equal to 75 micrometers (µm) or may be less than or equal to 45 micrometers (µm).

The second surface 304 of the polycrystalline substrate 300 may have a roughness less than or equal to 20 Angstrom (Å). In some embodiments, the second surface 304 of the polycrystalline substrate 300 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the second surface 304 may be obtained by polishing the second surface 304.

In at least one embodiment, the size of the grains 301 at the first surface 302 is the same or similar in size to the size of the grains 301 at the second surface 304. In at least one embodiment, the average size of the grains 301 at the first surface 302 is the same (*i.e*., equal to) or similar to the average size of the grains 301 at the second surface 304.

In at least one embodiment, the average grain size of the grains 301 taken along various locations (*i.e*., slices) of the thickness T4 of the polycrystalline substrate 300 remains the same *(i.e.,* equal to) or similar to each other. For example, if the polycrystalline substate 301 was cut in close proximity to the first surface 302 and the average grain size was measured, the average grain size at this slice in close proximity to the first surface 302 would be the same or similar to the average grain size at the second surface 304 or would be the same or similar to the average grain size measured at a slice taken anywhere else along the thickness T4 of the polycrystalline substrate 300. In other words, the average grain size taken along any slice at any location at or between the first surface 302 and the second surface 304 is the same (*i.e*., equal to) or similar to the average grain size at any other slice at any other location at or between the first surface 302 and the second surface 304 such that the average grain size is uniform along the entirety of the thickness T4 of the polycrystalline substrate 300.

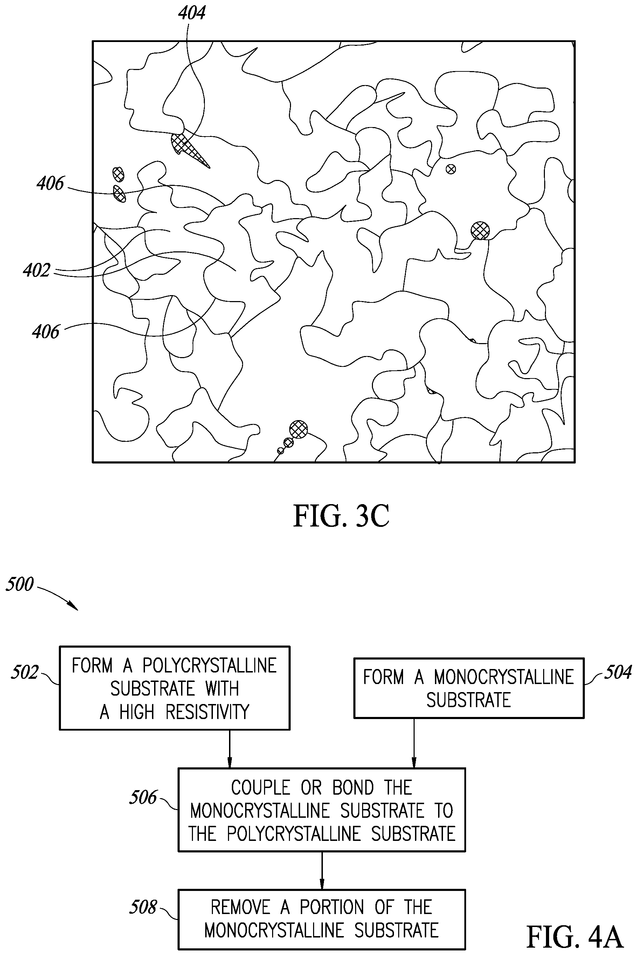

Figure 3C is a zoomed in, enhanced view of section 3C-3C as shown in Figure 3A of the embodiment of the polycrystalline substrate 300 as shown in Figure 3A. The polycrystalline substrate 300 includes grains 402 of silicon carbide (*e.g.,* SiC, SiC₂, etc.) that may be bonded together (see Figure 4A of the present disclosure). The grains 402 as shown in Figure 3C are the same as the grains 301 as shown in Figure 3A. This zoomed in enhanced view as shown in Figure 3C may be representative of a grain structure of the polycrystalline substrate 300 (see Figures 3A and 3B of the present disclosure) or a grain structure of the polycrystalline layers 106 of the wafers 100, 200 (see Figures 1 and 2 of the present disclosure). The polycrystalline substrate 300 is a non-columnar type polycrystalline such that the polycrystalline substrate 300 has randomly or amorphous oriented grains and does not have a columnar type structure. These randomly and amorphous oriented grains and non-columnar structures of the polycrystalline substrate 300 may be referred to as a non-oriented grain structure. This non-oriented grain structure may assist in increasing an overall resistivity of the polycrystalline substrate 300. The polycrystalline substrate 300 may include micro-pores 404 that may be present along grain boundaries 406 that are between the grains 402. The grain boundaries 406 are between adjacent pairs of respective grains of the grains 402. The carbon may be present at the grain boundaries 406 to adhere the grains 402 to each other in the polycrystalline layer 106. The grains 402 may have a size less than or equal to 1 millimeter (mm).

As discussed earlier herein, the polycrystalline layer 106 has a high resistivity, which may be formed utilizing the polycrystalline substrate 300 that also has the high resistivity. The polycrystalline substrate 300 may have a high resistivity by either reducing or limiting a number of the micro-pores 404 between the grains 402 along the grain boundaries 406 such that the polycrystalline substrate 300 has a resistivity greater than or equal to 1×10^5 ohm·centimeter. In some embodiments, the polycrystalline substrate 300 may have a low amount of nitrogen (N) doped within the polycrystalline substrate 300 to reduce and counter the effect of the presence of the micro-pores 404 within the polycrystalline layer 106. For example, in some embodiments, the polycrystalline layer 106 may be doped with a low amount of nitrogen such that a concentration of nitrogen (N) is less than or equal to 1E+16 atoms per cm³ *(i.e.,* 1 x 10¹⁶ atoms/cm³) in the polycrystalline substrate 300. The polycrystalline substrate 300 may be manufactured to have this low concentration of nitrogen by utilizing source gases with a purity of 99.9% purity or better or, alternatively, by using a solid source with high purity to reduce the concentration of nitrogen (N) present within the polycrystalline substrate 300 once formed.

In at least one embodiment, the polycrystalline substrate 300 has a resistivity greater than or equal to 1×10⁷ ohm·centimeters. In at least one embodiment, the polycrystalline substrate 300 has a resistivity greater than or equal to 1×10⁸ ohm·centimeters.

In view of the above discussion, by reducing the effect of the micro-pores 404 or by preventing the formation of the micro-pores 404 within the polycrystalline substrate 300, as well as providing the relatively large grains 402 (*i.e*., see discussion earlier herein with respect to grain sizes of grains 402) and large grain boundaries 406 the resistivity of the polycrystalline substrate 300 is increased. In at least some embodiments, the porosity of the polycrystalline substrate 300 ranges from 0 to 2%, or is equal to the upper and lower ends of this range. In at least some embodiments, the porosity of the polycrystalline substrate 300 is less than or equal to 2%. In at least some embodiments, the porosity of the polycrystalline substrate 300 is less than or equal to 1%. In other words, in an ideal world, the polycrystalline substrate 300 has no micro-pores 404 and there is a desire to avoid the micro-pores 404 being present within the polycrystalline substrate 300 such that the polycrystalline substrate 300 has no porosity.

In at least some embodiments, the polycrystalline substrate 300 has a purity of silicon-carbide (SiC) being greater than or equal to 98%. In at least some embodiments, the polycrystalline substrate has a purity of silicon-carbide (SiC) ranging from 99% to 100%, or is equal to the upper and lower ends of this range. In at least one embodiment of the polycrystalline substrate 300, the polycrystalline substrate 300 does not contain any metal or additive material and is purely composed of silicon-carbide (SiC). In other words, in view of these ranges of the purity and discussion of the purity of the polycrystalline substrate 300, in an ideal world, the polycrystalline substrate 300 is 100% pure silicon-carbide (SiC) and does not contain any additives (*i.e*., metal particles).

The polycrystalline substrate 300 has a density that is 98% greater than a monocrystalline SiC layer or substrate with a high resistivity. The polycrystalline substrate 300 having this much higher density as compared to the monocrystalline layer or substrate with a similar high resistivity further prevents points of lower resistance allowing for conduction to occur with less resistance between the grains 402. In at least one embodiment, the polycrystalline substrate 300 has a density ranging from 3.14 g/cm^3 (*i.e*., grams per centimeter cubed) to 3.21 g/cm^3, or has a density equal to the upper and lower ends of this range. In at least some embodiments, the polycrystalline substrate 300 has a density greater than or equal to 3.19 g/cm^3.

In at least one embodiment, the polycrystalline substrate 300 has a thermal conductivity ranging from 250 W/(m·K) (*i.e*., watts per meter kelvin) to 350 W/(m·K) or is equal to the upper and lower ends of this range. In at least one embodiment, the polycrystalline substrate 300 has a thermal conductivity greater than or equal to 300 W/(m·K). In other words, the polycrystalline substrate 300 has a relatively high thermal conductivity that allows for the polycrystalline substrate 300 to dissipate thermal energy or heat more effectively as compared to a respective polycrystalline substrate with a lower thermal conductivity. As the polycrystalline substrate 300 has a high resistivity, which is due to the relatively large grains 301, 402, the relatively large grain boundaries 406, and a low number or no micro-pores 404, and has the high thermal conductivity, the polycrystalline substrate 300 is effective and capable of being utilized with high power and high frequency applications.

In at least one embodiment, the polycrystalline substrate 300 has a transparency ranging from 97.5 % to 99.5%, or equal to the upper and lower ends of this range. In at least one embodiment, the polycrystalline substrate has a transparency greater than or equal to 98%.

In at least one embodiment, the polycrystalline substrate 300 has a crystal direction of 111. In at least one embodiment, the polycrystalline substrate 300 has a crystal direction of 111 in 60% to 90% of the grains, or is equal to the upper and lower ends of this range.

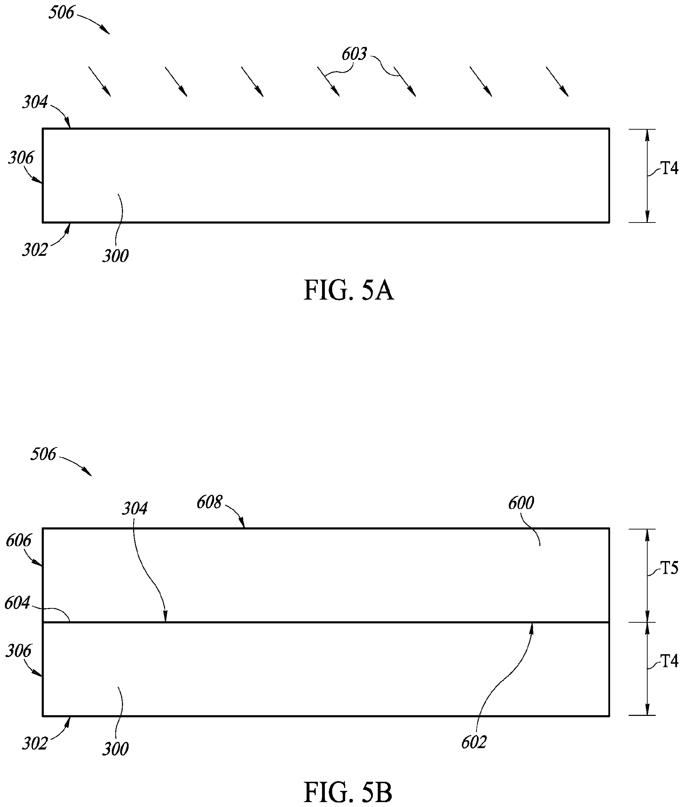

Figure 4A is directed to a flowchart 500 of an embodiment of a method of manufacturing the embodiments of the wafer 100 as shown in Figure 1 of the present disclosure. Figures 5A-5C are directed to side views of the respective steps 502, 504, 506, 508 in the flowchart 500 of the embodiment of the method of manufacturing the embodiment of the wafer 100 of the present disclosure.

In a polycrystalline substrate formation step 502, the polycrystalline substrate 300 with the high resistivity is formed. In a monocrystalline substrate formation step 504, a monocrystalline substrate 600 is formed. The polycrystalline substrate formation step 502, in which the polycrystalline substrate 300 is formed, and the monocrystalline substrate formation step 504, in which the monocrystalline substrate 600 is formed, may occur simultaneously within the semiconductor manufacturing plant (FAB) or may occur at different times within the FAB.

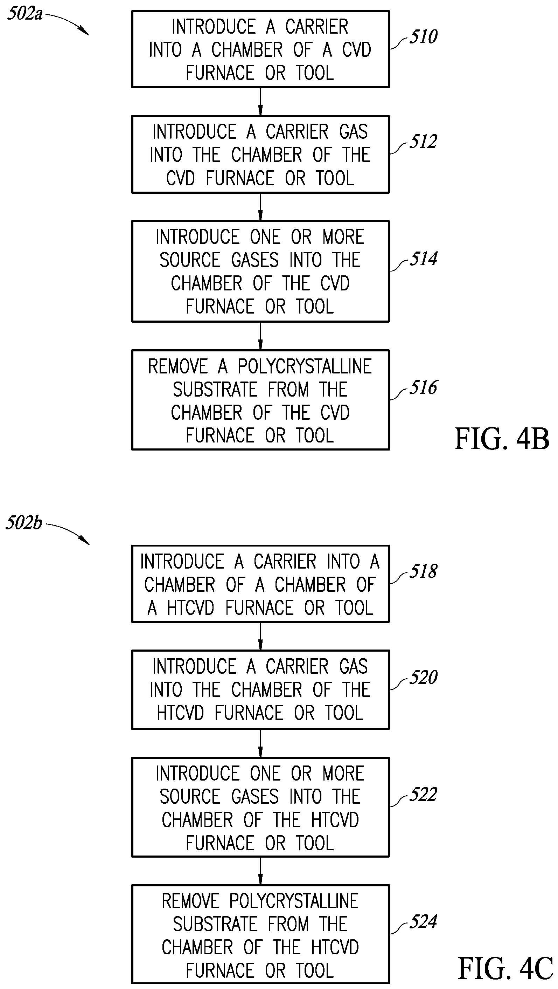

The polycrystalline substrate formation step 502 for forming the polycrystalline substrate 300 with the high resistivity may be carried out utilizing at least one of the embodiments of the methods of forming the polycrystalline substrate 300 as illustrated in the chemical vapor deposition (CVD) flowchart 502a as shown in Figure 4B, or a high temperature chemical vapor deposition (HTCVD) flowchart 502b as shown in Figure 4C.

When the polycrystalline substrate 300 is formed utilizing the method in the CVD flowchart 502a as shown in Figure 4B, in a first step 510 a carrier (*e.g*., a disk made of graphite, a dummy silicon substrate, or some other suitable type of carrier or temporary carrier on which a polycrystalline silicon carbide (SiC) may be formed) is inserted or introduced into a chamber of a CVD tool that is configured to perform or carry out a CVD process to form the polycrystalline substrate 300. The carrier may be a plate, may be a carrier substrate, or may be some other suitable type of carrier on which the polycrystalline substrate is formed. The carrier may be a polycrystalline carrier substrate or plate, may be a graphite carrier substrate or plate, or may be some other suitable type of carrier substrate or plate on which the polycrystalline substrate 300 is formed.

After the first step 510 in which the carrier is inserted or introduced into the chamber of the CVD tool, in a second step 512, the chamber is sealed, and a carrier gas is introduced into the chamber of the CVD tool. The carrier gas may be a hydrogen gas. In some embodiments, the carrier gas may be some other type of noble gas (*e.g*., argon, helium, etc.). The carrier gas is introduced at a flowrate of 100 liters per minute (l/min). This carrier gas is configured to or selected to enhance the chemical reaction within the chamber of the furnace of the CVD tool to grow polycrystalline silicon carbide (SiC) on the carrier within the chamber of the furnace of the CVD tool. In some embodiments, during the second step 512, the chamber of the furnace of the CVD tool may be heated within a range from 1250 to 1350 degrees Celsius (°C) or may be heated to a temperature equal to the upper and lower ends of this range (*e.g*., a temperature equal to 1250 degrees Celsius (°C) or a temperature equal to 1350 degrees Celsius (°C)). In some alternative embodiments, during the second step 512, the chamber of the furnace of the CVD tool may be heated a temperature equal to 1320 degrees Celsius (°C).

After the second step 512 in which the carrier gas has been introduced into the chamber of the furnace of the CVD tool and the chamber of the furnace of the CVD tool has been heated or heating has been initiated, in a third step 514, source gases are introduced to the chamber of the furnace of the CVD tool. The source gases include a carbon gas or carbon-based gas (*e.g*., ethene) and a silicon containing gas or silicon-based gas (e.g. silane, trichlorosilane (TCS), or some other similar silicon containing gas or silicon-based gas). When the source gases include ethene gas and silane gas, the ethene gas is introduced at a rate of 60 milliliters per minute (ml/min) and the silane gas is introduced at a rate of 80 milliliters per minute (ml/min). For example, the carbon gas or carbon based gas, which is the ethene gas in this instance, may be introduced into the chamber of the furnace of the CVD tool by introducing a solid source of ethene into the chamber of the furnace of the CVD tool, and the silicon containing gas or silicon based gas, which is silane gas in this instance, may be introduced into the chamber of the furnace of the CVD tool by introducing a solid source of silane into the chamber of the furnace of the CVD tool. Alternatively, respective fluidic pathways may be opened up that are in fluid communication with the chamber of the furnace of the CVD tool to introduce the carbon gas or carbon based gas (*i.e.,* the ethene gas) and the silicon containing gas or silicon based gas (*i.e.,* the silane gas). When these respective gases are introduced into the chamber of the CVD tool at this stage, these respective gases chemically react with each other resulting in polycrystalline silicon carbide (SiC) being formed and deposited onto the carrier resulting in the polycrystalline silicon carbide forming on a carrier surface of the carrier. When the carrier is a polycrystalline silicon carbide carrier substrate or plate, the polycrystalline silicon carbide formed by the reaction within the chamber of the CVD tool is deposited onto the polycrystalline silicon carbide carrier substrate or plate. When the carrier is a graphite carrier substrate or plate, the polycrystalline silicon carbide formed by the reaction within the chamber of the CVD tool is deposited onto the graphite carrier substrate or plate. The carrier has a polycrystalline structure such that the polycrystalline substrate 300 is capable of being formed on a respective surface of the carrier. The respective surface of the carrier has a roughness less than or equal to 5 nm (*i.e.,* nanometers). The respective surface of the carrier has the same or similar structure to the polycrystalline substrate 300 to be formed and grown on the carrier. In some situations, the respective surface of the carrier is treated with a surface treatment process before forming or growing the polycrystalline substrate 300 on the carrier. As the polycrystalline silicon carbide is formed in the chamber of the CVD tool, the polycrystalline silicon carbide substrate is formed. In some embodiments, the polycrystalline silicon carbide may be doped with a small amount of the nitrogen (*e.g.,* a concentration of nitrogen that is less than or equal to 1 × 10¹⁶ atoms/cm³).

The third step 514 in this process is carried out for between 1 to 4 hours, for 1 hour, or for 4 hours to form a selected thickness of the polycrystalline silicon carbide formed on the carrier. Performing the third step 514 for between 1 to 4 hours, for 1 hour, or for 4 hours results in the polycrystalline silicon carbide being formed having a thickness between 350 to 500 micrometers (µm), or a thickness equal to the upper and lower ends of this range.

After the third step 514 in which the carbon gas or carbon based gas (*i.e.,* the ethene gas) and the silicon containing gas or silicon based gas (*i.e.,* the silane gas) are introduced into the chamber of the furnace of the CVD tool while being heated to form the polycrystalline silicon carbide on the carrier, in a fourth step 516, the chamber of the CVD tool and the polycrystalline substrate 300 formed on the carrier are allowed to cool down to room temperature. As the polycrystalline substrate 300 cools down on the carrier, differences in thermal conductivity between the polycrystalline substrate 300 and the carrier may result in some warpage in the polycrystalline substrate 300. However, this warpage of the polycrystalline substrate 300 is less than or equal to 75 micrometers (µm) or may be less than or equal to 45 micrometers (µm). Once cooled down to room temperature, the polycrystalline substrate 300, which is coupled to the carrier, and the carrier are removed from the chamber of the CVD tool. After the polycrystalline substrate 300 and the carrier are removed from the chamber, the polycrystalline substrate 300 may be removed from the carrier and then further processed (*e*.*g*., polishing techniques, planarizing techniques, etc.), a portion of the polycrystalline substrate 300 may be sliced from the polycrystalline substrate 300 to form the polycrystalline layer 106 either when coupled to the carrier or after being removed from the carrier or before or after further processing, or the polycrystalline substrate may undergo other suitable types of processing techniques to further refine or process the polycrystalline substrate 300 to form various electronic devices or components.

After the polycrystalline substrate 300 is formed, the polycrystalline substrate 300 may be utilized to form the embodiment of the wafer 100 as shown in Figure 1 or the alternative embodiment of the wafer 200 as shown in Figure 2. For example, in at least one situation, the second surface 304 of the polycrystalline substrate 300 is polished or planarized such that the second surface 304 of the polycrystalline substrate 300 has a roughness less than or equal to 20 Angstrom (Å). In some embodiments, the second surface 304 of the polycrystalline substrate 300 has a roughness in the range of 1-5 Angstrom (Å) or has a roughness that is equal to the lower or upper ends of this range (*e.g.,* a roughness may be equal to 1 Angstrom (Å) or may be equal to 5 Angstrom (Å)). After the second surface 304 of the polycrystalline substrate 300 has been polished or planarized, the polycrystalline substrate 300 may then be utilized to form the embodiment of the wafer 100 as shown in Figure 1 or the alternative embodiment of the wafer 200 as shown in Figure 2.

When the method with the CVD tool as shown in the flowchart 502a is utilized to form polycrystalline substrate 300, the polycrystalline substrate 300 is made of a majority of a polycrystalline structure of 3C-SiC poly-type. For example, in some embodiments, the crystalline structure of the polycrystalline substrate 300 is made up of 80% of 3C-SiC poly-type. In some embodiments, the crystalline structure of the polycrystalline substrate 300 is made up of 50% to 100% of 3C-SiC poly-type, or may be equal to the upper and lower ends of this range (*e*.*g*., equal to 50% or equal to 100%). The polycrystalline substrate 300 has a high resistivity greater than 1×10^5 or 1E+5 ohm·centimeters.

When the polycrystalline substrate 300 is formed utilizing the method in the HTCVD flowchart 502b as shown in Figure 4C, in a first step 518 a carrier (*e.g.,* a disk made of graphite, a dummy silicon substrate, or some other suitable type of carrier or temporary carrier on which a polycrystalline silicon carbide (SiC) may be formed) is inserted or introduced into a chamber of an HTCVD tool that is configured to perform or carry out an HTCVD process to form the polycrystalline substrate 300. The carrier may be a plate, may be a carrier substrate, or may be some other suitable type of carrier on which the polycrystalline substrate is formed. The carrier may be a polycrystalline carrier substrate or plate, may be a graphite carrier substrate or plate, or may be some other suitable type of carrier substrate or plate on which the polycrystalline substrate is formed. The carrier has a polycrystalline structure such that the polycrystalline substrate 300 is capable of being formed on a respective surface of the carrier. The respective surface of the carrier has a roughness less than or equal to 5 nm (*i.e.,* nanometers). The respective surface of the carrier has the same or similar structure to the polycrystalline substrate 300 to be formed and grown on the carrier. In some situations, the respective surface of the carrier is treated with a surface treatment process before forming or growing the polycrystalline substrate 300 on the carrier.

After the first step 518 in which the carrier is inserted or introduced into the chamber of the HTCVD tool, in a second step 520, the chamber is sealed and a carrier gas is introduced into the chamber of the HTCVD tool. The carrier gas may be an argon gas, a helium gas, or a hydrogen gas. In some embodiments, the carrier gas may be some other type of noble gas. The carrier gas is introduced at a flowrate of 100 liters per minute (l/min). This carrier gas is configured to or selected to enhance the chemical reaction within the chamber of the furnace of the HTCVD tool to grow polycrystalline silicon carbide (SiC) on the carrier within the chamber of the furnace of the HTCVD tool. In some embodiments, during the second step 520, the chamber of the furnace of the HTCVD tool may be heated within a range from 2000 to 2500 degrees Celsius (°C) or may be heated to a temperature equal to the upper and lower ends of this range (*e.g.,* a temperature equal to 2000 degrees Celsius (°C) or a temperature equal to 2500 degrees Celsius (°C)). In some alternative embodiments, during the second step 520, the chamber of the furnace of the HTCVD tool may be heated to a temperature equal to 2250 degrees Celsius (°C).

After the second step 520 in which the carrier gas has been introduced into the chamber of the furnace of the HTCVD tool and the chamber of the furnace of the HTCVD tool has been heated or heating has been initiated, in a third step 522, source gases are introduced to the chamber of the furnace of the CVD tool. The source gases include a carbon gas or carbon-based gas (*e.g*., ethene) and a silicon containing gas or silicon-based gas (*e*.*g*., silane, trichlorosilane (TCS), or some other similar silicon containing gas or silicon-based gas). When the source gases include ethene gas and silane gas, the ethene gas is introduced at a rate of 46.7 milliliters per minute (ml/min) and the silane gas is introduced at a rate of 350 milliliters per minute (ml/min). For example, the carbon gas or carbon based gas, which is the ethene gas in this instance, may be introduced into the chamber of the furnace of the HTCVD tool by introducing a solid source of ethene into the chamber of the furnace the HTCVD tool, and the silicon containing gas or silicon based gas, which is silane gas in this instance, may be introduced into the chamber of the furnace of the HTCVD tool by introducing a solid source of silane into the chamber of the furnace of the HTCVD tool,. Alternatively, respective fluidic pathways may be opened up that are in fluid communication with the chamber of the furnace of the HTCVD tool to introduce the carbon gas or carbon based gas (*i.e.,* the ethene gas) and the silicon containing gas or silicon based gas (*i.e.,* the silane gas). When these respective gases are introduced into the chamber of the HTCVD tool at this stage, these respective gases chemically react with each other resulting in polycrystalline silicon carbide (SiC) being formed and deposited onto the carrier resulting in polycrystalline silicon carbide forming on a carrier surface of the carrier. When the carrier is a polycrystalline silicon carbide carrier substrate or plate, the polycrystalline silicon carbide formed by the reaction within the chamber of the HTCVD tool is deposited onto the polycrystalline silicon carbide carrier substrate or plate. When the carrier is a graphite carrier substrate or plate, the polycrystalline silicon carbide formed by the reaction within the chamber of the HTCVD tool is deposited onto the graphite carrier substrate or plate. As the polycrystalline silicon carbide is formed in the chamber of the HTCVD tool, the polycrystalline silicon carbide substrate is formed. In some embodiments, the polycrystalline silicon carbide may be doped with a small amount of the nitrogen, which is less than or equal to 1 × 10¹⁶ atoms/cm³.

The third step 522 in this process is carried out for between 1 to 4 hours, for 1 hour, or for 4 hours to form a selected thickness of the polycrystalline silicon carbide formed on the carrier. Performing the third step 522 for between 1 to 4 hours, for 1 hour, or for 4 hours results in the polycrystalline silicon carbide having a thickness between 350 to 500 micrometers (µm), or a thickness may be equal to the upper and lower ends of this range.

After the third step 522 in which the carbon gas or carbon based gas (*i.e.,* the ethene gas) and the silicon containing gas or silicon based gas (*i.e.,* the silane gas) is introduced into the chamber of the furnace of the HTCVD tool while being heated to form the polycrystalline silicon carbide on the carrier, in a fourth step 524, the chamber of the HTCVD tool and the polycrystalline substrate 300 formed on the carrier are allowed to cool down to room temperature. As the polycrystalline substrate 300 cools down on the carrier, differences in thermal conductivity between the polycrystalline substrate 300 and the carrier may result in some warpage in the polycrystalline substrate 300. However, this warpage of the polycrystalline substrate 300 is less than or equal to 75 micrometers (µm) or may be less than or equal to 45 micrometers (µm). Once cooled down to room temperature, the polycrystalline substrate 300, which is coupled to the carrier, and the carrier are removed from the chamber of the HTCVD tool. After the polycrystalline substrate 300 and the carrier are removed from the chamber, the polycrystalline substrate 300 may be removed from the carrier and then further processed (*e*.*g*., polishing techniques, planarizing techniques, etc.), a portion of the polycrystalline substrate 300 may be sliced from the polycrystalline substrate 300 to form the polycrystalline layer 106 either when coupled to the carrier or after being removed from the carrier or before or after further processing, or the polycrystalline substrate may undergo other suitable types of processing techniques to further refine or process the polycrystalline substrate 300 to form various electronic devices or components

After the polycrystalline substrate 300 is formed, the polycrystalline substrate 300 may be utilized to form the embodiment of the wafer 100 as shown in Figure 1 or the alternative embodiment of the wafer 200 as shown in Figure 2. For example, in at least one situation, the second surface 304 of the polycrystalline substrate 300 is polished or planarized such that the second surface 304 of the polycrystalline substrate 300 has a roughness less than or equal to 20 Angstrom (Å). In some embodiments, the second surface 304 of the polycrystalline substrate 300 has a roughness in the range of 1-5 Angstrom (Å) or has a roughness that is equal to the lower or upper ends of this range (*e.g.,* a roughness may be equal to 1 Angstrom (Å) or may be equal to 5 Angstrom (Å)). After the second surface 304 of the polycrystalline substrate 300 has been polished or planarized, the polycrystalline substrate 300 may then be utilized to form the embodiment of the wafer 100 as shown in Figure 1 or the alternative embodiment of the wafer 200 as shown in Figure 2.

In the monocrystalline substrate formation step 504, a monocrystalline substrate 600 (see Figure 5B) may be formed utilizing a method known within the semiconductor industry. For example, the monocrystalline substrate 600 may be formed by melting high-purity, semiconductor-grade silicon and then utilizing a seed crystal to initiate formation of the monocrystalline substrate.

Once the polycrystalline substrate 300 and the monocrystalline substrate 600 are formed, in a couple or bond step 506 of the flowchart 500 to form the embodiment of the wafer 100, the second surface 304 of the polycrystalline substrate 300 is bonded to a third surface 602 of the monocrystalline substrate 600 utilizing a surface activated bonding (SAB) technique. The third surface 602 of the monocrystalline substrate 600 may correspond to the third surface 116 of the monocrystalline layer 110 of the wafer 100.

When the SAB technique is utilized, the second surface 304 of the polycrystalline substrate 300 is exposed to a beam of neutral atoms or Argon (Ar) atoms as represented by arrows 603 in Figure 5A to activate and clean the second surface 304 of the polycrystalline substrate 300. The second surface 304 of the polycrystalline substrate 300 may have been planarized to be substantially flat and level as well as polished to have a roughness less than or equal to 20 Angstrom (Å). In some embodiments, the second surface 304 of the polycrystalline substrate 300 may have a roughness in the range of 1-5 Angstrom (Å) or equal to the lower and upper ends of this range (*e.g*., a roughness may be equal to 1 Angstrom (Å) or may be equal to 5 Angstrom (Å)) before being exposed to the beam of neutral atoms or Argon (Ar) atoms.

When the SAB technique is utilized, the third surface 602 of the monocrystalline substrate 600 is exposed to a beam of neutral atoms or Argon (Ar) atoms (not shown) to activate and clean the third surface 602 of the monocrystalline substrate 600. The third surface 602 of the monocrystalline substrate 600 may have been planarized to be substantially flat and level, as well as polished to have a roughness less than or equal to 20 Angstrom (Å). In some embodiments, the third surface 602 of the monocrystalline substrate 600 may have a roughness in the range of 1-5 Angstrom (Å) or equal to the lower and upper ends of this range (*e.g*., a roughness may be equal to 1 Angstrom (Å) or may be equal to 5 Angstrom (Å)) before being exposed to the beam of neutral atoms or Argon (Ar) atoms.

The fourth surface 610 of second portion 600b of the monocrystalline substrate 600 may have a roughness less than or equal to 20 Angstrom (Å). In some embodiments, the fourth surface 610 of the second portion 600b of the monocrystalline substrate 600 may have a roughness in the range of 1-5 Angstrom (Å) and may be equal to the lower and upper ends of this range (*e.g*., the roughness may be equal to 1 Angstrom (Å) or may be equal to 5 Angstrom (Å)). This roughness of the fourth surface 610 may be obtained by polishing or planarizing the fourth surface 610.

In some embodiments, a roughness at the first surface 302 of the polycrystalline substrate 300 may be greater than or equal to the roughness of the second surface 304 of the polycrystalline substrate 300. This roughness of the first surface 302 may be obtained by polishing or planarizing the first surface 302.

After the second surface 304 of the polycrystalline substrate 300 and the third surface 602 of the monocrystalline substrate 600 are cleaned and activated, the monocrystalline substrate 600 is flipped and the third surface 602 of the monocrystalline substrate 600, which is clean and activated, is contacted with the second surface 304 of the polycrystalline substrate 300, which is clean and activated, such that the clean and activated second surface 304 bonds with the clean and activated third surface 602 spontaneously resulting in the monocrystalline substrate 600 being bonded to the polycrystalline substrate 300 at a bonding region 604. When the monocrystalline substrate 600 is bonded to the polycrystalline substrate 300, a sidewall 606 of the monocrystalline substrate 600 is flush with the sidewall 306 of the polycrystalline substrate 300. The monocrystalline substrate 600 has a fifth thickness T5 that extends from the third surface 602 of the monocrystalline substrate 600 to a fourth surface 608 of the monocrystalline substrate 600 opposite to the third surface 602 of the monocrystalline substrate 600.

After the bonding step 506 in which the monocrystalline substrate 600 is bonded to the polycrystalline substrate 300, in a removal step 508, a first portion 600a is removed from a second portion 600b of the monocrystalline substrate 600. The first portion 600a may be removed from the second portion 600b by slicing the monocrystalline substrate 600 forming the first portion 600a and the second portion 600b. After the second portion 600b has been removed from the first portion 600a, the second portion 600b of the monocrystalline substrate 600 may be utilized again to form another wafer that is the same or similar to the wafer 100 by, for example, carrying out the bonding step 506 and the removal step 508 of the method of manufacturing in the flowchart 500. Removing the first portion 600a from the second portion 600b results in the sidewall 606 being broken up into a first sidewall 606a of the first portion 600a and a second sidewall 606b of the second portion 600b. After the first portion 600a is removed, the second sidewall 606b of the second portion 600b remains coplanar and flush with the sidewall 306 of the polycrystalline substrate 300. After the first portion 600a is removed, the second portion 600b remains bonded to the polycrystalline substrate 300 at the bonding region 604. After the first portion 600a is removed from the second portion 600b, the second portion 600b has the second thickness T2 that extends between the third surface 602 of the second portion 600b and a fourth surface 610 of the second portion 600b formed by removing the first portion 600a from the second portion 600b. After the first portion 600a is removed from the second portion 600b, the first portion has a sixth thickness T6 that extends from the fourth surface 608 of the first portion 600a to a fifth surface 612 of the first portion 600a that is opposite to the fourth surface of the first portion 600a. The sixth thickness T6 is less than the fifth thickness T5.

The second portion 600b of the monocrystalline substrate 600 may correspond to the monocrystalline layer 110 of the wafer 100, the polycrystalline substrate 300 may correspond to the polycrystalline layer 106 of the wafer 100, and the bonding region 604 may correspond to the bonding region 108 of the wafer 100. In other words, in some embodiments, after the first portion 600a is removed from the second portion 600b, the wafer 100 has been manufactured. In some alternative embodiments, some further processing steps such as grinding the first surface 302 of the polycrystalline substrate 300 may be performed to complete the manufacturing of the wafer 100.

As the monocrystalline substrate 600 is generally more expensive to manufacture relative to the polycrystalline substrate 300, bonding the monocrystalline substrate 600 to the high resistivity polycrystalline substrate 300 as a support and removing the first portion 600a from the second portion 600b reduces manufacturing costs as the monocrystalline substrate 600 may be utilized to form multiple ones of the wafers 100. In other words, while the cost of manufacturing the monocrystalline substrate may be expensive, the expense of manufacturing the monocrystalline substrate 600 may be spread out over multiple ones of the wafers 100 that are manufactured utilizing the method of manufacturing as in the flowchart 500.

In an alternative embodiment of the method of manufacturing in the flowchart 500, the first portion 600a of the monocrystalline substrate 600 may be removed from the second portion 600b of the monocrystalline substrate 600 before bonding the monocrystalline substrate 600 to the polycrystalline substrate 300. After the first portion 600a has been removed from the second portion 600b, the third surface 602 of the second portion 600b of the monocrystalline substrate 600 is bonded to the second surface 304 of the polycrystalline substrate 300. In other words, the removal step 508 occurs before the bonding step 506 in this alternative embodiment of the method of manufacturing the wafer 100.

While the above method as discussed in detail with respect to the flowchart in Figure 5A describes forming the wafer 100, the above method as discussed in detail with respect to the flowchart 500 in Figure 5A could be modified by forming a first conductive layer on the second surface 304 of the polycrystalline substrate 300 with a sputtering technique, forming a second conductive layer on the third surface 602 of the monocrystalline substrate 600, or forming only one of the first and second conductive layers, and then utilizing both the first conductive layer or only one of the first or second conductive layers to couple the polycrystalline substrate 300 to the monocrystalline substrate 600. This sputtering step may be performed or carried out between the first and second steps 502, 504 of the method as discussed in detail with respect to the flowchart 500 in Figure 5A. When this sputtering step is performed or carried out, the bonding layer 202 as shown in Figure 2 is formed resulting in the manufacturing of the alternative embodiment of the wafer 200.

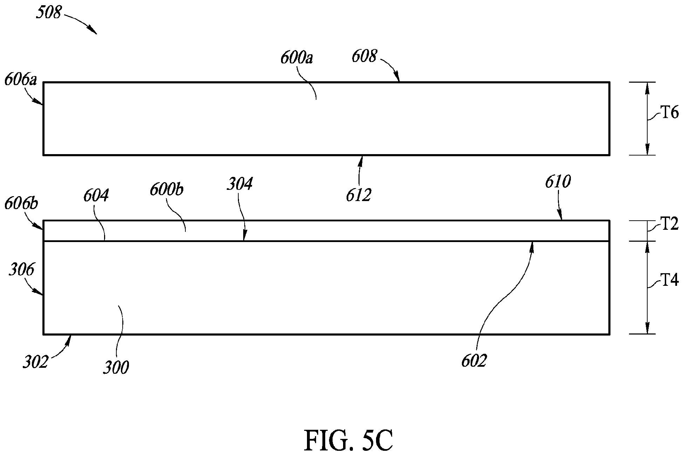

While not shown, the wafer 100 as shown in Figure 5C may be further processed and refined (*e.g.,* further layers (*e.g.,* conductive and non-conductive) formed on the monocrystalline layer 110, singulation of the wafer 100, back grinding wafer 100, etc.) to be utilized in forming electronic devices and components such as, for example, semiconductor packages or semiconductor devices. For example, a first electrode may be formed on the first side 102 of the wafer 100 and a second electrode may be formed on the second side 104 of the wafer 100 such that an electrical current may pass through the wafer 100 and the wafer 100 having the high resistivity allows for the wafer 100 to be utilized to high power and high frequency applications.

At least one embodiment of a device of the present disclosure is summarized as comprising: a polycrystalline silicon carbide (SiC) base substrate including: a first surface; a second surface opposite to the first surface; a resistivity greater than or equal to 1·10^5 ohm·centimeter (ohm·cm); and a grain size equal to or greater than 0.5 millimeters (mm); and a monocrystalline silicon carbide (SiC) substrate directly coupled to the first surface of the polycrystalline silicon carbide (SiC) base substrate.

The monocrystalline silicon carbide (SiC) substrate may have a thickness of at least one of the following of less than 1 micrometer (µm) and equal to 1 micrometer (µm)

The polycrystalline silicon carbide (SiC) base substrate may have a thickness greater than or equal to 300 micrometers (µm).

The polycrystalline silicon carbide (SiC) base substrate may have a thickness of at least one of the following of between 300 to 500 micrometers (µm), equal to 300 micrometers (µm), and equal to 500 micrometers (µm).

The resistivity of the polycrystalline silicon carbide (SiC) base substrate0 may be at least one of the following of between 1·10^5 ohm·cm to 1·10^12 ohm·cm, equal to 1·10^5 ohm·cm, and equal to 1·10^12 ohm·cm.

The resistivity of the polycrystalline silicon carbide (SiC) base substrate may be at least one of the following of between 1·10^5 ohm·cm to 1·10^9 ohm·cm, equal to 1·10^5 ohm·cm, and equal to 1·10^8 ohm·cm.

The first surface may have a roughness less than or equal to 5-angstrom (Å).

The grain size may be less than or equal to 5 millimeters (mm).

At least one embodiment of a device of the present disclosure is summarized as comprising: a polycrystalline silicon carbide (SiC) substrate including: a first surface; a second surface opposite to the first surface; a resistivity greater than or equal to 1·10^5 ohm·cm; and a grain size equal to or greater than 0.5 millimeters (mm).

The polycrystalline silicon carbide (SiC) substrate may have a thickness greater than or equal to 300 micrometers (µm).

The polycrystalline silicon carbide (SiC) substrate may have a thickness of at least one of the following of between 300 to 500 micrometers (µm), equal to 300 micrometers (µm), and equal to 500 micrometers (µm).

The resistivity of the polycrystalline silicon carbide (SiC) substrate may be at least one of the following of between 1·10^5 ohm·cm to 1·10^12 ohm·cm, equal to 1·10^5 ohm·cm, and equal to 1·10^12 ohm-cm.

The resistivity of the polycrystalline silicon carbide (SiC) substrate may be at least one of the following of between 1·10^5 ohm·cm to 1·10^9 ohm·cm, equal to 1·10^5 ohm·cm, and equal to 1·10^8 ohm-cm.

The first surface may have a roughness less than or equal to 5-angstrom (Å).

A majority of the polycrystalline silicon carbide (SiC) substrate may be made of a 4H-SiC crystal structure.

Eighty percent (80%) of the polycrystalline silicon carbide (SiC) substrate may be made of the 4H-SiC crystal structure.

The grain size may be less than or equal to 5 millimeters (mm).

At least one embodiment of a method of the present disclosure is summarized as comprising: forming a polycrystalline silicon carbide (SiC) base substrate with a resistivity greater than 1·10^5 ohm·cm and a grain size equal to or greater than 0.5 millimeters (mm) on a support substrate; and removing the polycrystalline silicon carbide (SiC) base substrate from the support substrate.

Forming the polycrystalline silicon carbide (SiC) base substrate may include: increasing a temperature within a chamber of an HTCVD (high-temperature chemical vapor deposition) furnace in which the support substrate is contained to be at least one of the following of between 2000 to 2500 degrees Celsius (°C), equal to 2000 degrees Celsius (°C), and 2500 degrees Celsius (°C); and introducing a silane source gas and an ethene source gas to a chamber growing the polycrystalline silicon carbide (SiC) base substrate on the support substrate.

Forming the polycrystalline silicon carbide (SiC) base substrate may include: increasing a temperature within a chamber of a CVD (chemical vapor deposition) furnace in which the support substrate is contained to be at least one of the following of between 1250 to 1350 degrees Celsius (°C), equal to 1250 degrees Celsius (°C), and equal to 1350 degrees Celsius (°C); and introducing a silane source gas and an ethene source gas to a chamber growing the polycrystalline silicon carbide (SiC) base substrate on the support substrate.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a polycrystalline silicon carbide, SiC, substrate including:
a first surface;
a second surface opposite to the first surface;
a resistivity greater than or equal to 1·10⁵ ohm·cm; and
a grain size equal to or greater than 0.5 mm.

2. The device of claim 1, further comprising a monocrystalline silicon carbide, SiC, substrate directly coupled to the first surface of the polycrystalline SiC substrate.

3. The device of claim 2, wherein the monocrystalline SiC substrate has a thickness of at least one of the following of less than 1 µm and equal to 1 µm.

4. The device of anyone of the preceding claims, wherein the polycrystalline SiC substrate has a thickness greater than or equal to 300 µm.

5. The device of claim 4, wherein the polycrystalline SiC substrate has a thickness of at least one of the following of between 300 to 500 µm, equal to 300 µm, and equal to 500 µm.

6. The device of anyone of the preceding claims, wherein the resistivity of the polycrystalline SiC substrate is at least one of the following of between 1·10⁵ ohm·cm to 1·10¹² ohm·cm, equal to 1·10⁵ ohm·cm, and equal to 1·10¹² ohm·cm.

7. The device of anyone of the preceding claims, wherein the resistivity of the polycrystalline SiC substrate is at least one of the following of between 1·10⁵ ohm·cm to 1·10⁹ ohm·cm, equal to 1·10⁵ ohm·cm, and equal to 1·10⁸ ohm·cm.

8. The device of anyone of the preceding claims, wherein the first surface has a roughness less than or equal to 0.5 nm.

9. The device of anyone of the preceding claims, wherein the grain size is less than or equal to 5 mm.

10. The device of anyone of the preceding claims, wherein a majority of the polycrystalline SiC substrate has a 4H-SiC crystal structure, or wherein 80% of the polycrystalline SiC substrate has the 4H-SiC crystal structure.

11. The device of anyone of the preceding claims, wherein the polycrystalline SiC substrate has a resistivity greater than or equal to 1·10⁷ ohm·cm or greater than or equal to 1·10⁸ ohm·cm.

12. The device of anyone of the preceding claims, wherein the polycrystalline SiC substrate has a purity greater than or equal to 98%.

13. The device of anyone of the preceding claims, wherein the polycrystalline SiC substrate has a density ranging from 3.14 grams/cm³ to 3.21 grams/cm3, or is equal to the upper and lower ends of this range, or is greater than or equal to 3.19 grams/cm³.

14. A method, comprising:
forming a polycrystalline silicon carbide, SiC, substrate with a resistivity greater than 1·10⁵ ohm·cm and a grain size equal to or greater than 0.5 mm on a surface of a support substrate, the support substrate is of a polycrystalline material and has a roughness less than or equal to 5 nm; and
removing the polycrystalline SiC base substrate from the support substrate.

15. The method of claim 14, wherein forming the polycrystalline SiC substrate includes one of a) and b):
a) increasing a temperature within a chamber of a high-temperature chemical vapor deposition, HTCVD, furnace in which the support substrate is contained to be at least one of the following of between 2000 to 2500 °C, equal to 2000 °C, and 2500 °C; and
introducing a silane source gas and an ethene source gas to a chamber growing the polycrystalline SiC substrate on the support substrate;
b) increasing a temperature within a chamber of a chemical vapor deposition, CVD, furnace in which the support substrate is contained to be at least one of the following of between 1250 to 1350 °C, equal to 1250 °C, and equal to 1350 °C; and
introducing a silane source gas and an ethene source gas to a chamber growing the polycrystalline SiC substrate on the support substrate.
